# EUROPÄISCHE PATENTANMELDUNG

(11) **EP 1 524 327 A1**
(43) Veröffentlichungstag der Anmeldung: **20.04.2005**
(21) Anmeldenummer: 03023523.8
(22) Anmeldetag: 15.10.2003
(51) Int. Cl.: C23C 4/06, C23C 4/08, C23C 14/06, C25D 15/00

(54) **Schicht mit intrakristallinen Einlagerungen**

(71) Anmelder: SIEMENS AKTIENGESELLSCHAFT, 80333 München (DE)
(72) Erfinder: Krüger, Ursus, Dr., 14098 Berlin (DE); Reiche, Ralph, 13465 Berlin (DE); Steinbach, Jan, 13353 Berlin (DE)

(57) **Zusammenfassung**

Schichten nach dem Stand der Technik weisen oft eine geringe thermische Beständigkeit auf.

Eine erfindungsgemäß ausgebildete Schicht (7) weist intrakristalline Einlagerungen (16) auf, die die thermische Beständigkeit deutlich erhöhen.

## Beschreibung

Die Erfindung betrifft eine Schicht mit intrakristallinen Einlagerungen.

Unter aggressiven Betriebsbedingungen degradieren Schichten häufig ebenso wie ihr unterliegendes Substrat. So rekristallisieren beispielsweise auch metallische Schichten.

Bei einer Gradientenschicht, die auf einem Substrat aufgebracht ist, steigt die Konzentration einer Sekundärphase beispielsweise ausgehend von der Oberfläche des Substrats hingehend zur äußeren Oberfläche der Schicht an.
Dadurch erreicht man beispielsweise eine Anpassung des Ausdehnungskoeffizienten oder der thermischen Leitfähigkeit an die Erfordernisse betrieblichen Einsatzes.

Bekannt sind metallische Schichten mit keramischen Bestandteile als interkristalline Einlagerungen.

Jedoch weisen solche Schichten keine hohe thermische Stabilität auf, weil sich ihre Mikrostruktur und damit die gewünschten Eigenschaften für den Einsatz der Schicht verändern.

Es ist daher Aufgabe der Erfindung, eine Schicht aufzuzeigen, die den oben angegebenen Nachteil überwindet.

Die Aufgabe wird gelöst durch eine Schicht gemäß Anspruch 1, bei dem eine Sekundärphase in Form von intrakristallinen Einlagerungen vorhanden ist.

In den Unteransprüchen sind weitere vorteilhafte Ausgestaltungen dargestellt.
Die in den Unteransprüchen aufgeführten Maßnahmen können in vorteilhafter Weise miteinander kombiniert werden.

Es zeigen
- Figur 1: eine erfindungsgemäße Schicht,
- Figur 2: eine weitere erfindungsgemäße Schicht,
- Figur 3, 4: jeweils eine schematische Darstellung der Mikrostruktur einer Schicht,
- Figur 5: eine Gasturbine und
- Figur 6: eine Brennkammer.

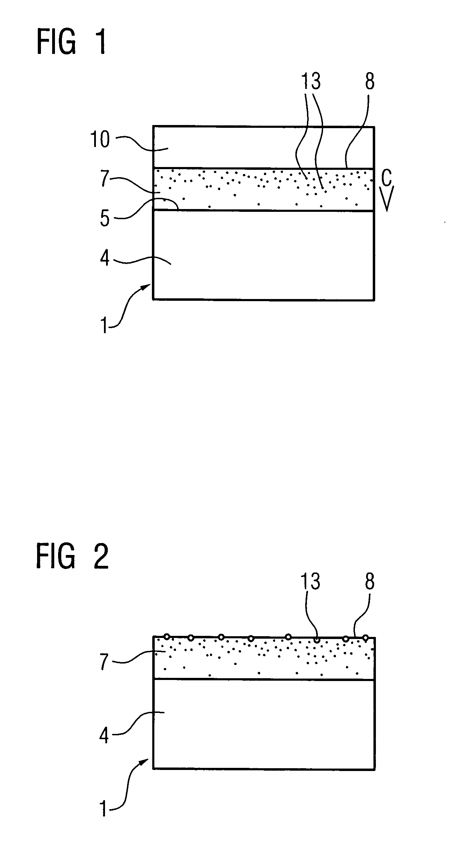

Figur 1 zeigt eine erfindungemäß ausgebildete Schicht 7 innerhalb eines Schichtsystems 1.
Dabei ist die Schicht 7 auf einem Substrat 4, beispielsweise einer eisen- nickel- oder kobaltbasierten Superlegierung, aufgebracht. Dies kann insbesondere durch ein elektrolytisches Verfahren erfolgen.

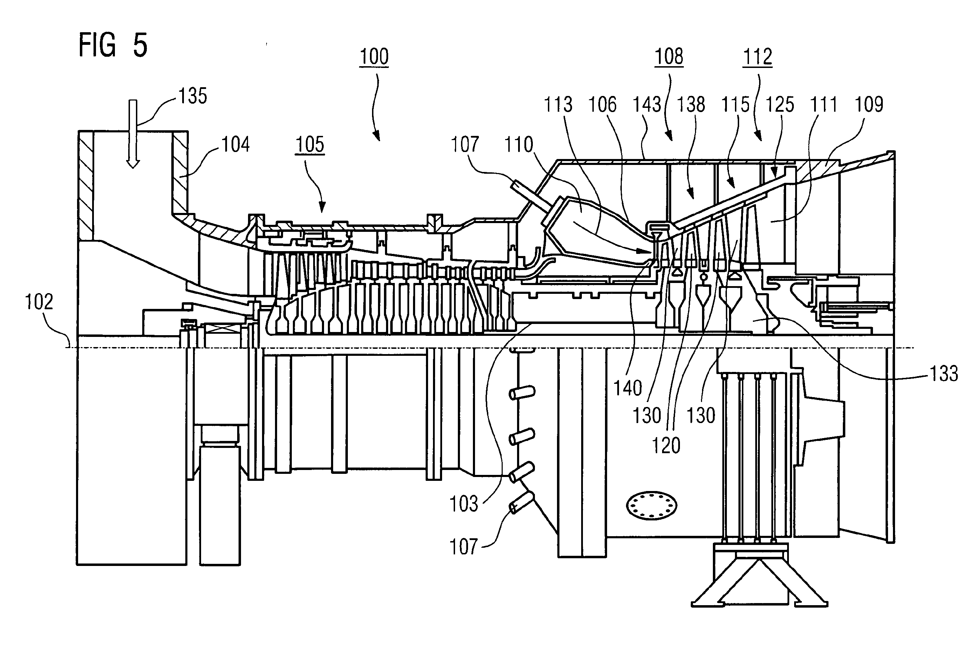

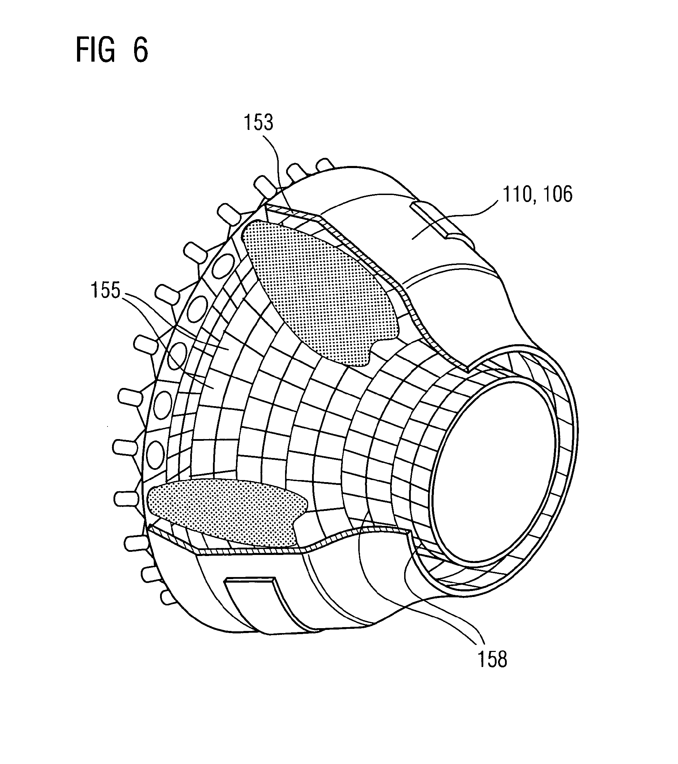

Eine solche Schicht 7 wird beispielsweise verwendet für Bauteile für Hochtemperaturanwendungen. Bauteile für Hochtemperaturanwendungen, also beispielsweise im Dampf- oder Gasturbinen 100 (Figur 5), einschließlich Flugzeugturbinen. Typische Bauteile mit Schichten 7 sind beispielsweise Turbinenschaufeln 120, 130 (Figur 5) und Brennkammerauskleidungen 155 (Figur 6).

Das Bauteil kann ein neu hergestelltes Bauteil sein oder ein wieder aufgearbeitetes Bauteil.

Wiederaufarbeitung (Refurbishment) bedeutet, dass Bauteile nach ihrem Einsatz gegebenenfalls von Schutzschichten befreit werden müssen (z.B. durch Sandstrahlen). Danach erfolgt eine Entfernung der Korrosions- und/oder Oxidationsschichten bzw. -produkte. Gegebenenfalls werden auch noch Risse eines Substrats repariert. Danach erfolgt eine Wiederbeschichtung des Substrats und ein erneuter Einsatz des Bauteils.

Ausgehend von der Oberfläche 5 des Substrats 4 hin zur Oberfläche 8 der Schicht 7 steigt beispielsweise die Konzentration c der Sekundärphase 13 in der beispielsweise verwendeten Legierung MCrAlX (M= Fe, Co, Ni; X = Aktivelement, wie z.B. Yttrium und/oder zumindest ein Element der Seltenen Erden) an.

Jeder anders geartete Verlauf (kontinuierliche Zunahme, Maximum oder Minimum in der Mitte) der Konzentration c der Sekundärphase ist denkbar.

Auf der Schicht 7 ist beispielsweise eine keramische Schicht 10 aufgebracht. Dies ist beispielsweise für Gasturbinenbauteile wie z.B. Turbinenschaufeln, eine keramische Wärmedämmschicht.

Die Sekundärphase 13 ist beispielsweise keramisch, kann aber auch metallisch sein.
Auch andere Kombinationen von Matrix/Sekundärphase wie Keramik/Keramik, oder Metall/Metall sind denkbar.
Die Sekundärphase 13 bildet beispielsweise Kristallisationskeime (Keimzellen) für die Bildung einer Oxidschicht auf der Schicht 7. Dies kann z.B. eine Aluminiumoxid sein, eine thermisch gewachsene Oxidschicht (TGO).

Vorzugsweise beinhaltet die Sekundärphase 13 das Material der keramischen Schicht 10 beispielsweise Zirkonoxid (ZrO₂, Y₂O₃ - ZrO₂,.....), so dass die keramische Schicht 10 besser auf der Schicht 7 aufwachsen kann, beispielsweise beim EB-PVD-Beschichten (electron beam physical vapour deposition).

Figur 2 zeigt eine Schicht 7, die an ihrer Oberfläche 5 behandelt worden ist.

In einem ersten Verfahrensschritt wird die Schicht 7 wie bei Figur 1 beschrieben auf das Substrat 4 aufgebracht. Die Konzentration der Sekundärphase 13 kann an der Oberfläche 5 so erhöht werden, dass fast nur noch oder allein das Material der Sekundärphase 13 an der Oberfläche 5 vorhanden ist.

Es kann aber auch sein, dass die Sekundärphase 13 von dem Material der Schicht 7 umhüllt ist oder bedeckt ist.
In diesem Fall wird dieses Material teilweise abgetragen. Dies kann beispielsweise durch chemisches Ätzen oder Plasmaätzen erfolgen. Da beispielsweise das Material der Matrix metallisch ist und leichter abgetragen wird als die keramische Sekundärphase, ragt die Sekundärphase aus der Oberfläche der Schicht 7 heraus.
Die Oberfläche 5 ist dann rau und bietet beste Voraussetzungen für eine gute Haftung einer noch aufzubringenden Schicht. Die Oberfläche der Schicht 7 wird durch das Material der Matrix und der Sekundärphase 13 gebildet, letztere kann dann in vorteilhafter Weise als Keimzelle für eine weitere Beschichtung dienen.
Alternativ kann die Oberfläche dann noch poliert werden, wobei die Sekundärphase 13, die aus der Oberfläche herausragt, abgetragen wird, aber weiterhin das Material der Sekundärphase 13 einen Teil der
äußeren Fläche bildet.
Alternativ kann aber auch so Material direkt durch Polieren abgetragen werden, also Material der Matrix und Sekundärphase 13, dass eine ebene, glatte Oberfläche aus Matrix und Sekundärphase sich bildet.
Wichtig in diesem Fall ist nur, dass die Sekundärphase 13 einen Teil der Oberfläche 8 bildet.

Es ist außerdem bekannt metallische Werkstücke mit einkristalliner Struktur oder Strukturen als Bauteile von Maschinen zu verwenden, die im Betrieb hohen mechanischen, thermischen und/oder chemischen Belastungen ausgesetzt sind. Beispielsweise werden Schaufeln von Gasturbinen, insbesondere auch von Rotoren für Flugzeug-Triebwerke, aber auch solche für stationäre Gasturbinen, aus Einkristallen hergestellt.

Die Fertigung von derartigen einkristallinen Werkstücken erfolgt z.B. durch gerichtetes Erstarren aus der Schmelze. Es handelt sich dabei um Gießverfahren, bei denen die flüssige metallische Legierung zur einkristallinen Struktur, d.h. zum einkristallinen Werkstück, oder gerichtet erstarrt.
Dabei werden dendritische Kristalle entlang dem Wärmefluss ausgerichtet und bilden entweder eine stängelkristalline Kornstruktur (kolumnar, d.h. Körner, die über die ganze Länge des Werkstückes verlaufen und hier, dem allgemeinen Sprachgebrauch nach, als gerichtet erstarrt bezeichnet werden) oder eine einkristalline Struktur, d.h. das ganze Werkstück besteht aus einem einzigen Kristall. In diesen Verfahren muss man den Übergang zur globulitischen (polykristallinen) Erstarrung meiden, da sich durch ungerichtetes Wachstum notwendigerweise transversale und longitudinale Korngrenzen ausbilden, welche die guten Eigenschaften des gerichtet erstarrten oder einkristallinen Bauteiles zunichte machen.
Wenn in der vorliegenden Schrift von einkristalliner Struktur und einkristallinen Strukturen die Rede ist, so sind damit sowohl Einkristalle, die keine Korngrenzen aufweisen, als auch Kristallstrukturen, die wohl Korngrenzen, die longitudinal verlaufen, aber keine Korngrenzen, die in transversaler Richtung verlaufen, aufweisen. Bei diesen zweitgenannten kristallinen Strukturen spricht man auch von gerichtet erstarrten Gefügen (directionally solidified structures).

Ist allgemein von gerichtet erstarrten Gefügen die Rede, so sind damit sowohl Einkristalle gemeint, die keine Korngrenzen oder höchstens Kleinwinkelkorngrenzen aufweisen, als auch Stängelkristallstrukturen, die wohl in longitudinaler Richtung verlaufende Korngrenzen, aber keine transversalen Korngrenzen aufweisen.

Solche Verfahren sind aus der US-PS 6,024,792 und der EP 0 892 090 A1 bekannt.

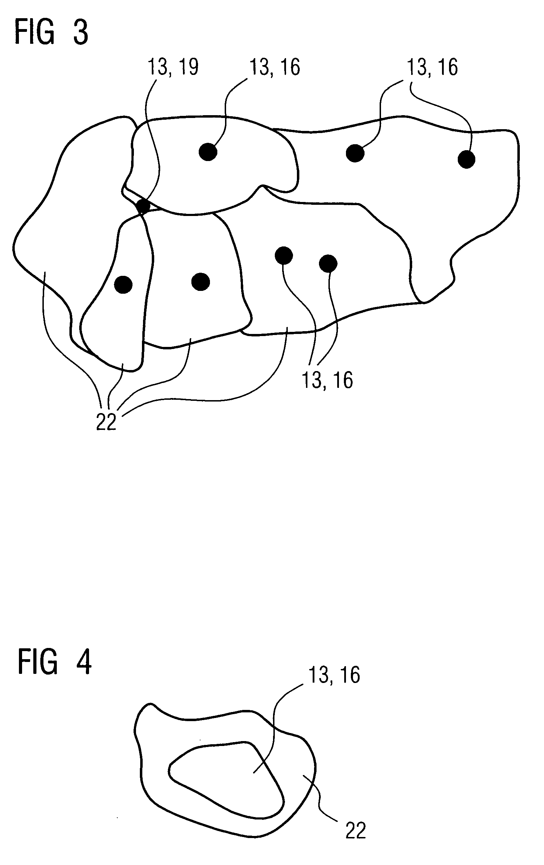

Figur 3 zeigt beispielhaft die Mikrostruktur einer Schicht 7. Die Schicht 7, die auch einkristallin oder kolumnar ausgebildet sein könnte, ist hier polykristallin (granular). Die einkristalline Schicht 7 besteht aus einem Korn 22. In diesem Korn 22 ist die Sekundärphase 13 immer intrakristallin vorhanden.
Bei einer kolumnaren Struktur (nicht dargestellt) besteht die Schicht 7 aus mehreren stängelförmigen Körnern 22, die sich in eine Richtung erstrecken. Im letzteren Fall besteht die Schicht 7 aus vielen Körnern 22.
In den Körnern 22 ist intrakristallin die Sekundärphase 13 eingelagert.
Es können zusätzlich auch interkristalline Einlagerungen 19 vorhanden sein.
Die Anzahl, Größe und Lage der intrakristallinen 16 bzw. interkristallinen Einlagerungen 19 in einem und/oder um ein Korn 22 kann mit den Verfahrensparametern des gewählten Beschichtungsprozesses eingestellt werden.
So können beim elektrolytischen Beschichten bspw. keramische Körner im Nanometerbereich (Nanokörner) im Elektrolyt vorhanden, d.h. suspendiert sein, die die intrakristallinen Einlagerungen 19 ergeben sollten. Die Matrix (metallisch) wird mittels gelöster Ionen im Elektrolyt elektrolytisch abgeschieden, die die Nanokörner umschliessen und so einen intrakristallinen Einschluss 19 ergeben.
Insbesondere wenn die Konzentration der Sekundärphase 13 zur Oberfläche hin ansteigt, stellt die Sekundärphase 13 den größten Volumenanteil in einem Korn 22 dar (Figur 4).

Eine solche Schicht 7 wird beispielsweise mit einem elektrolytischen Verfahren hergestellt, wobei für die Sekundärphase 13, 16, 19 sehr kleine Körner, insbesondere deutlich kleiner als 1µm verwendet werden. Es können aber auch noch Körner kleiner 0.5µm oder bis 50nm oder 1nm vorhanden sein.

Die Sekundärphase 13 ist in dem Elektrolyten bei der elektrolytischen Beschichtung enthalten (suspendiert, aufgelöst), wobei der Prozess so gesteuert wird, dass sich die Sekundärphase 13 in dem Korn 22 intrakristallin und gegebenenfalls zusätzlich interkristallin einlagert.

Ebenso können aus einer polykristallinen Schicht 7 durch entsprechende schmelztexturierende Erstarrungsverfahren kolumnare oder einkristalline Strukturen erzeugt werden, indem die granulare Schicht aufgeschmolzen und gerichtet erstarren gelassen wird.

Durch die Einlagerungen 16, 19 kann beispielsweise die Rekristallisation der Schicht 7, insbesondere einer metallischen Schicht 7, reduziert oder verhindert werden. In jedem Fall wird erfindungsgemäß eine hohe Phasenstabilität und thermische Stabilität erreicht, da sich die Mikrostruktur, die die Eigenschaften der Schicht 7 beeinflusst, gar nicht oder kaum ändert.
Ein weiterer positiver Effekt der Einlagerungen 16, 19 in der Schicht 7 kann die Wirkung als Kristallisationskeime (Keimzellen) für die Bildung weiterer Schichten auf der Schicht 7 sein.
Das Wachstumsverhalten einer noch aufzubringenden Schicht 10 auf die Schicht 7 wird beeinflusst durch die Mikrostruktur der Schicht 7. Bei einer Beschichtung auf die Einlagerungen 16, 19 in der Schicht 7 mit ähnlicher oder gleicher Kristallstruktur an der Oberfläche 8 orientiert sich das Material der Schicht 10 beim Aufwachsen an der Kristallstruktur der Einlagerungen 16, 19.
Somit kann das Wachstumsverhalten einer noch aufzubringenden Schicht 10 durch die Einlagerungen 16, 19 gesteuert werden.

Die Figur 5 zeigt eine Gasturbine 100 in einem Längsteilschnitt.
Die Gasturbine 100 weist im Inneren einen um eine Rotationsachse 102 drehgelagerten Rotor 103 auf, der auch als Turbinenläufer bezeichnet wird. Entlang des Rotors 103 folgen aufeinander ein Ansauggehäuse 104, ein Verdichter 105, eine beispielsweise torusartige Brennkammer 110, insbesondere Ringbrennkammer 106, mit mehreren koaxial angeordneten Brennern 107, eine Turbine 108 und das Abgasgehäuse 109. Die Ringbrennkammer 106 kommuniziert mit einem beispielsweise ringförmigen Heißgaskanal 111. Dort bilden beispielsweise vier hintereinandergeschaltete Turbinenstufen 112 die Turbine 108. Jede Turbinenstufe 112 ist aus zwei Schaufelringen gebildet. In Strömungsrichtung eines Arbeitsmediums 113 gesehen folgt im Heißgaskanal 111 einer Leitschaufelreihe 115 eine aus Laufschaufeln 120 gebildete Reihe 125.

Die Leitschaufeln 130 sind dabei am Stator 143 befestigt, wohingegen die Laufschaufeln 120 einer Reihe 125 mittels einer Turbinenscheibe 133 am Rotor 103 angebracht sind. An dem Rotor 103 angekoppelt ist ein Generator oder eine Arbeitsmaschine (nicht dargestellt).

Während des Betriebes der Gasturbine 100 wird vom Verdichter 105 durch das Ansauggehäuse 104 Luft 135 angesaugt und verdichtet. Die am turbinenseitigen Ende des Verdichters 105 bereitgestellte verdichtete Luft wird zu den Brennern 107 geführt und dort mit einem Brennmittel vermischt. Das Gemisch wird dann unter Bildung des Arbeitsmediums 113 in der Brennkammer 110 verbrannt. Von dort aus strömt das Arbeitsmedium 113 entlang des Heißgaskanals 111 vorbei an den Leitschaufeln 130 und den Laufschaufeln 120. An den Laufschaufeln 120 entspannt sich das Arbeitsmedium 113 impulsübertragend, so dass die Laufschaufeln 120 den Rotor 103 antreiben und dieser die an ihn angekoppelte Arbeitsmaschine.

Die dem heißen Arbeitsmedium 113 ausgesetzten Bauteile unterliegen während des Betriebes der Gasturbine 100 thermischen Belastungen. Die Leitschaufeln 130 und Laufschaufeln 120 der in Strömungsrichtung des Arbeitsmediums 113 gesehen ersten Turbinenstufe 112 werden neben den die Ringbrennkammer 106 auskleidenden Hitzeschildsteinen am meisten thermisch belastet. Um den dort herrschenden Temperaturen standzuhalten, werden diese mittels eines Kühlmittels gekühlt. Zum Teil weisen die Schaufeln 120, 130 erfindungsgemäße Schichten 7 (Fig. 1, 2, 3, 4) gegen Korrosion (MCrAlX; M = Fe, Co, Ni, X=Y, Seltenen Erden) und Wärme (Wärmedämmschicht, beispielsweise ZrO₂, Y₂O₄-ZrO₂) auf.

Die Leitschaufel 130 weist einen dem Innengehäuse 138 der Turbine 108 zugewandten Leitschaufelfuß (hier nicht dargestellt) und einen dem Leitschaufelfuß gegenüberliegendem Leitschaufelkopf auf. Der Leitschaufelkopf ist dem Rotor 103 zugewandt und an einem Befestigungsring 140 des Stators 143 festgelegt.

Die Figur 6 zeigt eine Brennkammer 110 einer Gasturbine.
Die Brennkammer 110 ist beispielsweise als so genannte Ringbrennkammer ausgestaltet, bei der eine Vielzahl von in Umfangsrichtung um die Turbinenwelle 103 herum angeordneten Brennern 102 in einen gemeinsamen Brennkammerraum münden. Dazu ist die Brennkammer 110 in ihrer Gesamtheit als ringförmige Struktur ausgestaltet, die um die Turbinenwelle 103 herum positioniert ist.

Zur Erzielung eines vergleichsweise hohen Wirkungsgrades ist die Brennkammer 110 für eine vergleichsweise hohe Temperatur des Arbeitsmediums M von etwa 1000°C bis 1600°C ausgelegt. Um auch bei diesen, für die Materialien ungünstigen Betriebsparametern eine vergleichsweise lange Betriebsdauer zu ermöglichen, ist die Brennkammerwand 153 auf ihrer dem Arbeitsmedium M zugewandten Seite mit einer aus Hitzeschildelementen 155 gebildeten Innenauskleidung versehen. Jedes Hitzeschildelement 155 ist arbeitsmediumsseitig mit einer besonders hitzebeständigen Schutzschicht, insbesondere mit einer Schicht 7 gemäß Figur 3, ausgestattet oder aus hochtemperaturbeständigem Material gefertigt. Aufgrund der hohen Temperaturen im Inneren der Brennkammer 110 ist zudem für die Hitzeschildelemente 155 bzw. für deren Halteelemente ein Kühlsystem vorgesehen.

Die Brennkammer 110 ist insbesondere für eine Detektion von Verlusten der Hitzeschildelemente 155 ausgelegt. Dazu sind zwischen der Brennkammerwand 153 und den Hitzeschildelementen 155 eine Anzahl von Temperatursensoren 158 positioniert.

## Patentansprüche

1. Schicht (7) mit intrakristallinen Einlagerungen (16).

2. Schicht nach Anspruch 1,
**dadurch gekennzeichnet, dass**
die Schicht (7) einen Gradienten der Materialzusammensetzung,
insbesondere einen Gradienten in der Konzentration der intrakristallinen Einlagerungen (16), aufweist.

3. Schicht nach Anspruch 1 oder 2,
**dadurch gekennzeichnet, dass**
die Schicht (7) einkristallin ausgebildet ist.

4. Schicht nach Anspruch 1 oder 2,
**dadurch gekennzeichnet, dass**
die Schicht (7) kolumnar ausgebildet ist.

5. Schicht nach Anspruch 1 oder 2,
**dadurch gekennzeichnet, dass**
die Schicht (7) polykristallin ausgebildet ist.

6. Schicht nach Anspruch 1, 2, 4 oder 5,
**dadurch gekennzeichnet, dass**
die Schicht (7) interkristalline Einlagerungen (19) aufweist.

7. Schicht nach einem oder mehreren der vorhergehenden Ansprüche 1 bis 5,
**dadurch gekennzeichnet, dass**
die Schicht (7) ein erstes Material und die intrakristallinen Einlagerungen (16) ein zweites Material aufweisen, wobei das erste Material metallisch und das zweite Material keramisch ist.

8. Schicht nach einem oder mehreren der vorhergehenden Ansprüche 1 bis 5,
**dadurch gekennzeichnet, dass**
die Schicht (7) ein erstes Material und die intrakristalline Einlagerungen (16) ein zweites Material aufweist, wobei das erste und das zweite Material metallisch ist.

9. Schicht nach einem oder mehreren der vorhergehenden Ansprüche 1 bis 5,
**dadurch gekennzeichnet, dass**
die Schicht (7) ein erstes Material und die intrakristalline Einlagerungen (16) ein zweites Material aufweist, wobei das erste Material keramisch und das zweite Material metallisch ist.

10. Schicht nach einem oder mehreren der vorhergehenden Ansprüche 1 bis 5,
**dadurch gekennzeichnet, dass**
die Schicht (7) ein erstes Material und die intrakristallinen Einlagerungen (16) ein zweites Material aufweist, wobei das erste und zweite Material keramisch sind.

11. Schicht nach Anspruch 1, 6, 7, 8, 9 oder 10,
**dadurch gekennzeichnet, dass**
die intrakristallinen und/oder interkristallinen Einlagerungen (16,19) eine Korngröße kleiner 1µm aufweisen.

12. Schicht nach Anspruch 1, 6, 7, 8, 9 oder 10,
**dadurch gekennzeichnet, dass**
die intrakristallinen und/oder interkristallinen Einlagerungen (16,19) eine Korngröße kleiner 0,5µm, insbesondere im Nanometerbereich aufweisen.

13. Schicht nach Anspruch nach einem der Ansprüche 7 bis 10,
**dadurch gekennzeichnet, dass**
das erste Material höchstens teilweise abgetragen wurde, so dass die Oberfläche der Schicht zumindest teilweise aus dem zweiten Material besteht.

14. Schicht nach Anspruch 13,
**dadurch gekennzeichnet, dass**
die Abtragung durch chemisches oder plasmagestütztes Ätzen erfolgt.

15. Schicht nach Anspruch 1,
**dadurch gekennzeichnet, dass**
die Schicht (7) elektrolytisch hergestellt worden ist.

16. Schicht nach Anspruch 1, 6 oder 13,
**dadurch gekennzeichnet, dass**
die intrakristallinen (16) und/oder interkristallinen (19) Einlagerungen Keimzellen für eine nachfolgende Schicht (10), insbesondere für eine EB-PVD-Schicht, auf der Schicht (7) sind.

17. Schicht nach Anspruch 1,
**dadurch gekennzeichnet, dass**
ein Bauteil einer Gas- (100) oder Dampfturbine, insbesondere eine Turbinenschaufel (120, 130), eine Brennkammerauskleidung (155) oder andere Gehäuseteile eine solche Schicht (7) aufweisen.

18. Schicht nach Anspruch 18,
**dadurch gekennzeichnet, dass**
das Bauteil neu hergestellt ist.

19. Schicht nach Anspruch 18,
**dadurch gekennzeichnet, dass**
das Bauteil wiederaufgearbeitet ist.
